# EUROPÄISCHE PATENTANMELDUNG

(11) **EP 1 772 529 A1**
(43) Veröffentlichungstag der Anmeldung: **11.04.2007**
(21) Anmeldenummer: 05021897.3
(22) Anmeldetag: 07.10.2005
(51) Int. Cl.: C23C 4/02, C23C 8/04, C23C 14/04, C23C 16/04, C23C 18/06, C22C 1/04

(54) **Trockene Zusammensetzung, Verwendung derer, Schichtsystem und Verfahren zur Beschichtung**

(71) Anmelder: SIEMENS AKTIENGESELLSCHAFT, 80333 München (DE)
(72) Erfinder: Karmazin, Roman, 81673 München (DE); Walter, Steffen, Dr., 85630 Harthausen (DE)

(57) **Zusammenfassung**

Beschichtungsverfahren sollen oft nur lokal angewendet werden.
Dabei können nicht immer lokale Beschichtungsverfahren verwendet, werden, sodass häufig eine Maskierung verwendet werden muss.

Die erfindungsgemäße Schutzschicht (7) enthält einen Binder und Titanoxid und kann erfindungsgemäß als Diffusionsbarriere verwendet werden, sodass bei einem Beschichtungsverfahren nur lokal das Beschichtungsmaterial aufgetragen wird.

Der Binder wird vor der Beschichtung in Kohlenstoff umgewandelt.

## Beschreibung

Die Erfindung betrifft eine trockene Zusammensetzung, eine Verwendung derer, ein Schichtsystem und ein Verfahren zur Beschichtung.

In vielen Beschichtungsverfahren ist oft nur eine lokale Beschichtung erforderlich. Dies kann bei allen gängigen Beschichtungsverfahren der Fall sein, wie z. B. beim Plasmaspritzen (atmosphärisches Plasmaspritzen APS, Niedrigdruckplasmaspritzen LPPS, VPS ...) oder bei PVD- sowie CVD-Verfahren. Auch bei dem so genannten Packverfahren, bei dem das zu beschichtende Bauteil in ein Pulverbett eingebracht wird, wird manchmal verlangt, dass nur eine lokale Beschichtung erfolgen soll.
Ebenso wird manchmal eine Maskierung gefordert, wenn ein Beschichtungsverfahren, das eine lokale Beschichtung ohne weitere Hilfsmittel erlaubt, benutzt wird. Dies ist z. B. bei Schlickerverfahren der Fall, wobei der Schlicker lokal aufgebracht und durch Erwärmung des Schlickers das Beschichtungsmaterial nur lokal ein- oder aufgebracht wird, aber eine Dampfwolke des Beschichtungsmaterials sich auf anderen Bereichen des Bauteils niederschlagen kann.

Es ist daher Aufgabe der Erfindung eine Zusammensetzung für eine Schutzschicht als Maskierung aufzuzeigen, die einfach verwendet werden kann.

Die Aufgabe wird gelöst durch eine trockene Zusammensetzung gemäß Anspruch 1 und durch eine Verwendung derer gemäß Anspruch 5.

Außerdem ist es Aufgabe der Erfindung ein Schichtsystem aufzuzeigen, das eine lokale Beschichtung eines Bauteils ermöglicht und bei dem eine Schutzschicht als Maskierung leicht entfernt werden kann.
Die Aufgabe wird gelöst durch ein Schichtsystem gemäß Anspruch 6.

Außerdem ist es Aufgabe der Erfindung ein Beschichtungsverfahren aufzuzeigen, bei dem eine lokale Beschichtung eines Bauteils erzeugt werden kann und bei dem die Maskierung leicht entfernt werden kann.
Die Aufgabe wird gelöst durch ein Verfahren gemäß Anspruch 11.

Die in den Unteransprüchen aufgelisteten Maßnahmen können beliebig in vorteilhafter Art und Weise miteinander kombiniert werden.

Es zeigen
- Figur 1, 2: schematisch ein Bauteil mit einer großflächigen Maskierung,
- Figur 3, 4: schematisch ein Bauteil mit lokaler Maskierung und ein Verfahren zur Beschichtung,
- Figur 5, 6: weitere Ausführungsbeispiele der Erfindung,
- Figur 7: eine perspektivische Ansicht einer Gasturbine,
- Figur 8: eine perspektivische Ansicht einer Brennkammer,
- Figur 9: eine perspektivische Ansicht einer Turbinenschaufel.

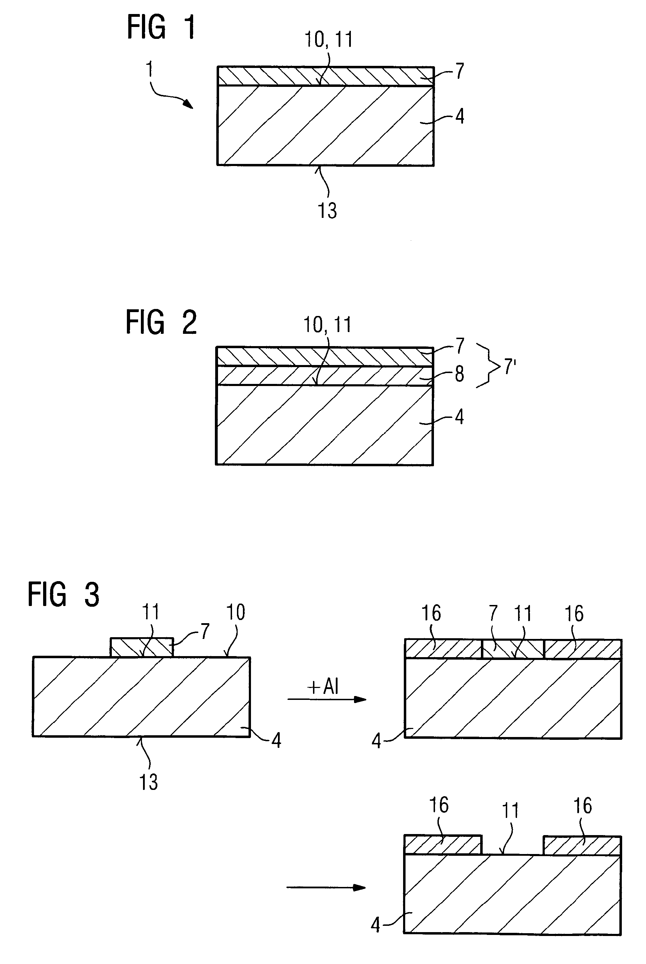

Figur 1 zeigt ein Bauteil 1, das aus einem Substrat 4 besteht, auf der eine Schutzschicht 7 aufgebracht ist.

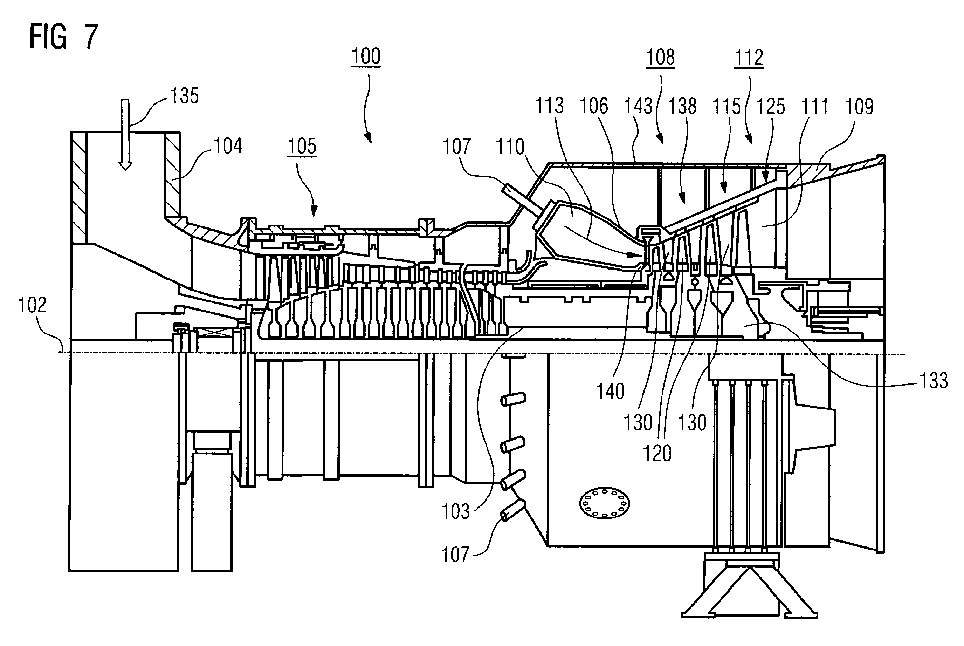

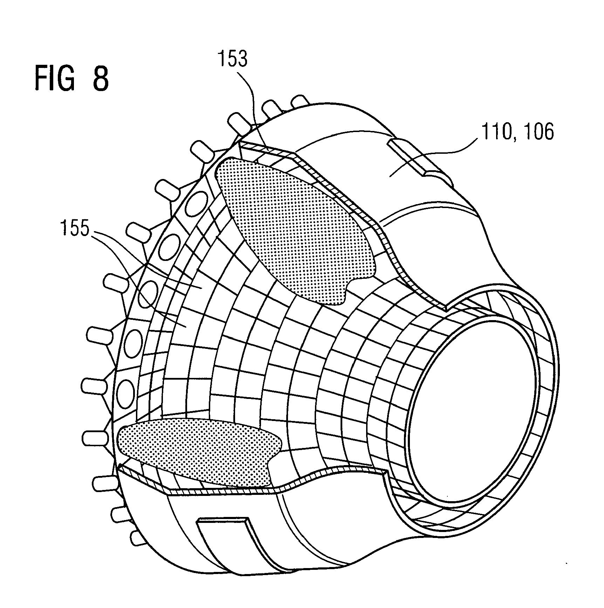

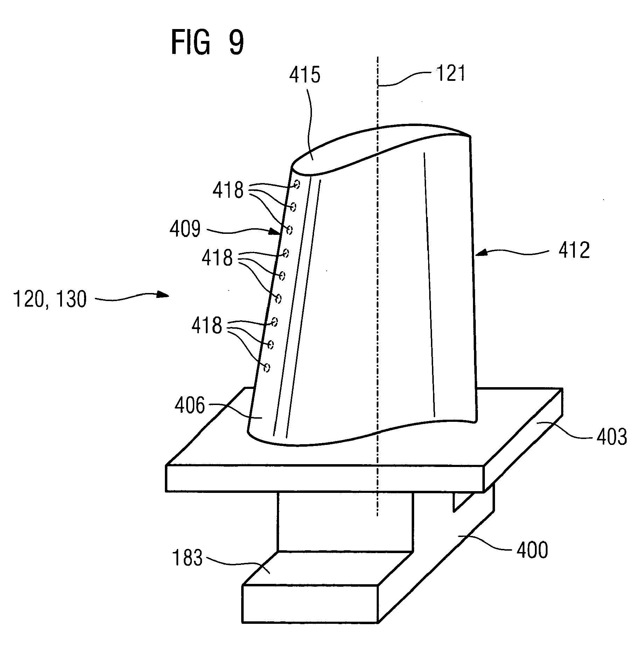

Das Bauteil 1 kann eine Turbinenschaufel 120, 130 (Figur 9), ein Gehäuse 138 (Figur 7) oder ein Brennkammerelement 155 (Fig. 8) einer Dampf- oder Gasturbine 100 (Fig. 7) sowie jedes beliebige Bauteil sein, das mittels eines bekannten Beschichtungsverfahrens beschichtet wird.

Das Substrat 4 hat eine äußere Oberfläche 10 und eine innere Oberfläche 13, wobei die äußere Oberfläche 10 nicht in einem Beschichtungsverfahren beschichtet werden soll, so dass die äußere Oberfläche 10 den nicht zu beschichtenden Bereich 11 darstellt. Daher wird die Schutzschicht 7 auf der gesamten Oberfläche 11 aufgebracht.

Die Schutzschicht 7 umfasst eine erfindungsgemäße trockene Zusammensetzung bestehend aus Kohlenstoff (C) und Nickel (Ni)-Pulver.
Der Kohlenstoff kann in chemisch gebundener Form mit anderen chemischen Elementen, insbesondere als organischer Binder vorliegen, der sich bei einer Wärmebehandlung (Aushärten) in Kohlenstoff umwandelt.
Der Kohlenstoff der trockenen Zusammensetzung kann zumindest teilweise, insbesondere vollständig in chemisch gebundener Form vorliegen.

Ebenso kann der Kohlenstoff der trocknen Zusammensetzung zumindest teilweise oder vollständig aus einem Kohlenstoffpulver, beispielsweise aus Graphitpulver oder aus Ruß gebildet sein.

Vorzugsweise besteht der Kohlenstoff der trockenen Zusammensetzung aus Kohlenstoff in Pulverform und einem Binder, der in einem Wärmebehandlungsverfahren in Kohlenstoff umgewandelt wird.

Die trockene Zusammensetzung kann in Form einer Paste oder eines Schlickers auf die Oberfläche 11 eines Bauteils 1, 120, 130, 138, 155 aufgetragen werden.

Die Schutzschicht 7 kann auf jede Oberfläche 10 oder 13 des Bauteils 1, 120, 130 aufgebracht werden und wird vorzugsweise als Schlicker großflächig, aber auch lokal begrenzt auf das Bauteil 1, 120, 130, 138 ,155 aufgetragen.

Der Binder ist entweder so weich (viskos), dass er als Paste aufgetragen werden kann oder es wird zu der trockenen Zusammensetzung ein Lösungsmittel (beispielsweise Wasser, Alkohol) hinzu gegeben, das die Viskosität hinreichend erniedrigt. Vorzugsweise wird als Binder mit Novolak vermischt. Das Grundharz Novolak ist ein Polymerprodukt aus Phenol und/oder Kresol und Formaldehyd, das durch Polykondensationsreaktion gebildet wird. Die Anzahl der Kettensegmente n beträgt etwa 1000 bis 2000. Novolak ist ein sehr sprödes Material, sein Erweichungspunkt liegt etwa bei 100°C.
Weiterer nichtkohlenstoffhaltiger Binder oder ein anderer kohlenstoffhaltiger Binder kann zu der trocknen Zusammensetzung, der Paste oder zu dem Schlicker hinzugefügt werden.

Vor dem Beschichten kann der Binder und/oder das Trägermittel ausgetrieben werden und vorzugsweise das Nickel- Kohlenstoffpulver versintert werden.

Die Schutzschicht 7 eignet sich vorzugsweise bei Gasphasenbeschichtungsverfahren wie z. B. dem PVD- oder CVD-Verfahren, bei dem eine Dampfwolke aus einem Material auf eine Oberfläche abgeschieden wird. Dabei wird durch die Schutzschicht 7 eine Maskierung gebildet, die als Diffusionsbarriere wirkt, indem das Nickel mit dem gasförmigen Beschichtungsmaterial reagiert.

Bei der Aluminisierung eines Bauteils 1 reagiert das Nickel zu Nickelaluminium (bspw. Al₃Ni), wodurch sich die Schutzwirkung der Schutzschicht 7 weiterhin verstärkt.
Das Beschichtungsmaterial kann nicht durch diese Schutzschicht 7 dringen.

Die so entstandene Schutzschicht 7 ist oft sehr spröde und kann dabei durch ein einfaches Entschichtungsverfahren wie z. B. Trockeneisstrahlen entfernt werden.

Ebenso kann eine solche Schutzschicht 7 bei einer Chromierung verwendet werden.

Vorzugsweise wird die Ni/C Zusammensetzung bei nickelbasierten Werkstoffen verwendet, da hier eine Diffusion von Nickel des Substrats 4 in die Maskierung oder eine Reaktion von Nickel des Substrats 4 mit der nickelhaltigen Schutzschicht 7 verringert oder sogar verhindert wird, da ein Konzentrationsgradient vorhanden ist, der dem entgegenwirkt.
Durch den insbesondere höheren Nickelanteil in der Schutzschicht 7 während des Beschichtungsverfahrens bildet sich ein Nickelkonzentrationsgradient aus. Dieser verhindert die Diffusion von Nickel aus dem Grundmaterial in die oberflächennahen Schichten. Die höhere Nickelkonzentration in der Schutzschicht 7 auf der Oberfläche 11 des Substrats 4 wirkt der Nickeldiffusion im Substrat 4 entgegen und unterbindet dessen Entmischung.

Bei einer Alitierung einer nickelbasierten Legierung mit einer Schutzschicht ohne Nickel entsteht durch Nickeldiffusion entsteht tiefer im Substrat eine 40µm breite Entmischungsschicht an, die chrom- und aluminiumreiche Bereiche aufweist, wobei dann tiefer im Substrat 4 das Substrat 4 im Ausgangszustand vorliegt.
Nachdem das Bauteil 1, 120, 130 im Einsatz war, wird auch der Bereich der Entmischungsschicht mit abgetragen. Dies ist natürlich nicht gewollt.

Durch die Verwendung der trockenen Zusammensetzung mit Nickel und Kohlenstoff ist es möglich sowohl die Diffusion von Aluminium während eines Beschichtungsverfahrens als auch die Entstehung der Entmischungsschicht zu verhindern.

Figur 2 zeigt eine weitere erfindungsgemäße Schutzschicht 7'. Die Schutzschicht 7' ist zweilagig aufgebaut, wobei die Schutzschicht 7 die Zusammensetzung wie in Figur 1 beschrieben aufweist. Jedoch ist unterhalb der Schutzschicht 7 eine weitere Schicht 8 vorhanden, die insbesondere direkt auf dem Substrat 4 aufliegt. Die Schutzschicht 8 ist eine kohlenstoffhaltige Schicht, die entweder nur aus Kohlenstoff oder Kohlenstoffprecursormaterialien, wie z. B. organischen Materialien besteht.
Vorzugsweise besteht die Schicht 8 aus Kohlenstoffpulver und einem Binder, für den wiederum vorteilhafterweise Novolak verwendet wird.
Diese kohlenstoffhaltige Schicht erlaubt die leichtere Entfernung der Schutzschicht 7, nachdem das Bauteil 1, 120, 130, 155 beschichtet wurde, da die Kohlenstoffschicht 8 nicht mit dem Substrat 4 reagiert und auch nicht mit dem Beschichtungsmaterial in Kontakt kommt.
Vorzugsweise wird auch dieses zweilagige Schichtsystem 7' bei einer Alitierung verwendet.

Figur 3 zeigt schematisch einen Verfahrensablauf eines erfindungsgemäßen Beschichtungsverfahrens.
Das Substrat 4 soll in einem Bereich 11 nicht beschichtet werden, so dass lokal eine Paste oder ein Schlicker auf die Oberfläche 10 im Bereich der nicht zu beschichtenden Oberfläche 11 aufgebracht wird, um eine Schutzschicht 7 zu bilden. Dann wird das Bauteil 1, 120, 130, 155 dem Beschichtungsverfahren ausgesetzt, beispielsweise einem Aluminiumdampf, wobei sich dann eine Aluminiumschicht 16 auf der Oberfläche 10 bildet, bis auf den Bereich, in dem die Schutzschicht 7 vorhanden ist.

Nach dem Entfernen der mit Aluminium angereicherten Schutzschicht 7 oder der Reaktionsprodukte von Schutzschicht 7 und Beschichtungsmaterial, hier Aluminium, ist eine lokale Beschichtung entstanden (Figur 3 ganz rechts).

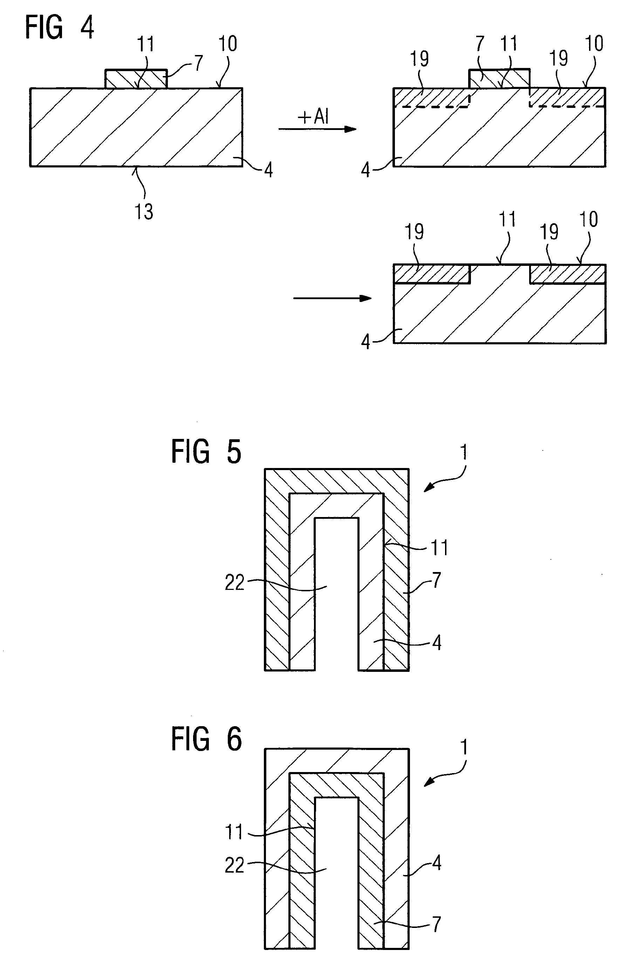

Figur 4 zeigt einen vergleichbaren und schematischen Verfahrensablauf wie in Figur 3, mit dem Unterschied, dass sich hier keine Schicht 16 auf der Oberfläche 10 bildet, sondern dass das Beschichtungsmaterial, hier ebenfalls beispielsweise Aluminium, in das Substrat 4 lokal eindringt, sodass sich lokale Bereiche 19 mit einem erhöhten Aluminiumgehalt ausbilden.

Figur 5 zeigt ein weiteres Ausführungsbeispiel des erfindungsgemäßen Verfahrens und einer weiteren Verwendung der Schutzschicht 7.

Das Bauteil 1, 120, 130, 155 weist einen Hohlraum 22 auf, der allein ganz oder lokal beschichtet werden soll. Dies ist beispielsweise der Fall, wenn die äußere Oberfläche des Substrats 4 bereits eine MCrAlX-Schicht und ggf. eine keramische Schicht aufweist, aber der Hohlraum 22 ebenfalls zu Korrosionsschutzzwecken aluminisiert oder chromiert werden soll. Dann wird auf die äußere Oberfläche 10 des Substrats 4 oder einer äußeren Beschichtung auf dem Substrat 4 eine Paste oder ein Schlicker zur Erzeugung einer Schutzschicht 7 aufgetragen, sodass kein Beschichtungsmaterial auf die äußere Oberfläche 11 gelangen kann und nur eine Beschichtung im Hohlraum 22 stattfindet.

Ebenso kann es möglich sein, dass die äußere Oberfläche eines hohlen Bauteils 1, 120, 130 beschichtet werden soll, beispielsweise soll eine MCrAlX-Schicht oder ein Substrat 4 zu Korrosionsschutzzwecken aluminisiert oder chromiert werden, wobei aber der Hohlraum 22 nicht beschichtet werden soll. Hier wird ebenfalls eine Paste oder ein Schlicker zur Erzeugung einer Schutzschicht 7 in den Hohlraum 22 eingebracht, der den Hohlraum 22 vor einer Beschichtung schützt (Figur 6).

Die Figur 7 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierungen Teil der Offenbarung.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1, die bzgl. der chemischen Zusammensetzung Teil dieser Offenbarung sein sollen.

Auf der MCrAlX kann noch eine Wärmedämmschicht vorhanden sein, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Die Figur 8 zeigt eine Brennkammer 110 einer Gasturbine 100. Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.
Jedes Hitzeschildelement 155 aus einer Legierung ist arbeitsmediumsseitig mit einer besonders hitzebeständigen Schutzschicht (MCrAlX-Schicht und/oder keramische Beschichtung) ausgestattet oder ist aus hochtemperaturbeständigem Material (massive keramische Steine) gefertigt.
Diese Schutzschichten können ähnlich der Turbinenschaufeln sein, also bedeutet beispielsweise MCrAlX: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.

Auf der MCrAlX kann noch eine beispielsweise keramische Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in dem Hitzeschildelement 155 repariert. Danach erfolgt eine Wiederbeschichtung der Hitzeschildelemente 155 und ein erneuter Einsatz der Hitzeschildelemente 155.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Filmkühllöcher (nicht dargestellt) auf.

Figur 9 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierung Teil der Offenbarung.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt; diese Schriften sind Teil der Offenbarung.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein.

Wenn die Schaufel 120, 130 gekühlt werden soll, ist sie hohl und weist ggf. noch Filmkühllöcher 418 (gestrichelt angedeutet) auf.

## Patentansprüche

1. Trockene Zusammensetzung,
bestehend aus
Kohlenstoff (C)
und Nickel (Ni)-Pulver.

2. Trockene Zusammensetzung nach Anspruch 1,
bei der
der Kohlenstoff zumindest teilweise,
insbesondere vollständig,
in chemisch gebundener Form mit anderen chemischen Elementen,
insbesondere als organischer Binder,
vorliegt,
die bzw. der durch eine Wärmebehandlung in Kohlenstoff umwandelbar ist.

3. Trockene Zusammensetzung nach Anspruch 1,
bei der
der Kohlenstoff der trockenen Zusammensetzung zumindest teilweise, insbesondere vollständig,
in Pulverform vorliegt.

4. Trockene Zusammensetzung nach Anspruch 1, 2 oder 3,
bei der
der Kohlenstoff der trockenen Zusammensetzung in chemisch gebundener Form und in Pulverform vorliegt.

5. Verwendung der trockenen Zusammensetzung gemäß Anspruch 1, 2, 3 oder 4 in Form einer Paste oder eines Schlickers, insbesondere zur Bildung einer Schutzschicht (7, 7') bei einem Beschichtungsprozess eines Bauteils (1, 120, 130, 138, 155).

6. Schichtsystem umfassend ein Substrat (4) für ein Bauteil (1, 120, 130, 138, 155) und einer Schutzschicht (7, 7'),
**dadurch gekennzeichnet, dass**
die Schutzschicht (7, 7')
die eine trockene Zusammensetzung gemäß Anspruch 1, 2, 3 oder 4 enthält.

7. Schichtsystem nach Anspruch 6,
**dadurch gekennzeichnet, dass**
die Schutzschicht (7') zumindest zweilagig aufgebaut ist, wobei auf dem Substrat (4) eine kohlenstoffhaltige Schicht (8) vorhanden ist,
auf der eine äußere Schicht (7),
enthaltend eine trockene Zusammensetzung gemäß Anspruch 1, 2, 3 oder 4,
vorhanden ist.

8. Schichtsystem nach Anspruch 7,
**dadurch gekennzeichnet, dass**
die kohlenstoffhaltige Schicht (8) durch ein Kohlenstoffpulver und/oder chemisch gebundenen Kohlenstoff, insbesondere einen organischen Binder,
gebildet ist.

9. Schichtsystem nach Anspruch 6 oder 7,
**dadurch gekennzeichnet, dass**
das Substrat (4) eine nickelbasierte Legierung darstellt.

10. Schichtsystem nach Anspruch 9,
**dadurch gekennzeichnet, dass**
der Nickelanteil in der Schutzschicht (7', 7) zumindest gleich, insbesondere höher ist als der Nickelanteil im Substrat (4).

11. Verfahren zur Beschichtung,
bei dem zuerst die trockene Zusammensetzung gemäß Anspruch 1, 2, 3 oder 4 als Paste oder als Schlicker auf zumindest einen nicht zu beschichtenden Bereich (11) eines Substrats (4) eines Bauteils (1, 120, 130, 138, 155) aufgebracht wird
und in einem weiteren Schritt des Verfahrens das Bauteil (1, 120, 130, 138, 155),
das eine Schutzschicht (7,7') aufweist,
beschichtet wird.

12. Verfahren nach Anspruch 11,
**dadurch gekennzeichnet, dass**
es über eine Gasphase erfolgt.

13. Verfahren nach Anspruch 11 oder 12,
**dadurch gekennzeichnet, dass**
es eine Aluminisierung darstellt.

14. Verfahren nach Anspruch 11,
**dadurch gekennzeichnet, dass**
die Paste oder der Schlicker durch Sprayen oder Aufpinseln auf den nicht zu beschichtenden Bereich (11) aufgetragen wird.

15. Verfahren nach Anspruch 11, 12, 13 oder 14,
**dadurch gekennzeichnet, dass**
nach dem Beschichtungsprozess das Reaktionsprodukt aus trockener Zusammensetzung und Beschichtungsmaterial, insbesondere durch Trockeneisstrahlen,
entfernt wird.

16. Verfahren nach Anspruch 11,
**dadurch gekennzeichnet, dass**
als Substrat (4) des Bauteils (1, 120, 130, 138, 155) ein nickelbasiertes Material verwendet wird.

17. Verfahren nach Anspruch 16,
**dadurch gekennzeichnet, dass**
der Nickelanteil in der Schutzschicht (7', 7) aus der trockenen Zusammensetzung gemäß Anspruch 1, 2, 3 oder 4 zumindest gleich,
insbesondere höher,
ist als der Nickelanteil im Substrat (4).
